# EUROPEAN PATENT APPLICATION

(11) **EP 4 088 846 A1**
(43) Date of publication of application: **16.11.2022**
(21) Application number: 21738408.0
(22) Date of filing: 07.01.2021
(51) Int. Cl.: B23K 1/20, B23K 1/00, B23K 31/02

(54) **DEOXIDIZED MEMBER PRODUCTION METHOD AND DEOXIDIZING DEVICE**

(30) Priority: 09.01.2020 JP 2020002402
(71) Applicant: Origin Company, Limited, Saitama-shi Saitama 338-0823 (JP)
(72) Inventor: OZAWA, Naoto, Saitama-shi, Saitama 338-0823 (JP); MATSUDA, Jun, Saitama-shi, Saitama 338-0823 (JP); MARUYAMA, Megu, Saitama-shi, Saitama 338-0823 (JP)
(74) Representative: Wallin, Nicholas James
(86) International application number: PCT/JP2021/000373
(87) International publication number: WO 2021/141087

(57) **Abstract**

The deoxidizing device comprises a chamber, an evacuation unit for evacuating a fluid in the interior of the chamber, a heating unit for heating a member, a reducing gas supply unit having a vaporizer for generating a reducing gas, and a control device. The control device controls each of the units in such a manner as to evacuate substantially entirely the fluid in the interior of the chamber, and then, while heating a member T, fill substantially the reducing gas into the chamber to 1,000 Pa or higher but lower than the saturation vapor pressure of the reducing gas. The deoxidized member production method comprises: introducing the member into the chamber and heating same at a predetermined temperature; evacuating substantially entirely the fluid in the interior of the chamber; and thereafter, filling substantially the reducing gas into the chamber to 1,000 Pa or higher but lower than the saturation vapor pressure of the reducing gas, to reduce the oxides in the member being heated at a predetermined temperature, under the reducing gas atmosphere.

## Description

### TECHNICAL FIELD

The present disclosure relates to a method for manufacturing an oxide-removed object and an oxide removing apparatus and, in particular, to a method for manufacturing an oxide-removed object and an oxide removing apparatus that reduce a time required for removal of an oxide.

### BACKGROUND ART

There is a case where, in a reflow soldering process to mount an electronic component on a substrate, an oxide present on the substrate is reduced by using formic acid in order to eliminate need to clean a flux residue after soldering. An example of this reflow soldering process is as follows. An object to be joined is placed on a carrier plate in a chamber, gas in the chamber is discharged, and formic acid gas, which is produced by being bubbled with carrier gas, is supplied into the chamber. Then, a heater is turned on to increase a temperature of the carrier plate, in turn, a temperature of the object to be joined to a reduction temperature for removal of an oxidized film and to further increase the temperature of the carrier plate, in turn, the temperature of the object to be joined to a joint temperature, at which solder is melted, for solder joint (for example, see Japanese Patent No. 5687755 B).

### SUMMARY OF THE INVENTION

### PROBLEM TO BE SOLVED BY THE INVENTION

In the above-described reflow soldering step, a considerable period of time is required from time at which the object to be joined is placed in the chamber to time at which a soldered product is manufactured and taken out from the chamber. For this reason, it has been desired to reduce a processing time for improved productivity.

The present disclosure has been made in view of the above-described problem and therefore relates to a method for manufacturing an oxide-removed object and an oxide removing apparatus that reduce a time required for removal of an oxide.

### MEANS FOR SOLVING THE PROBLEM

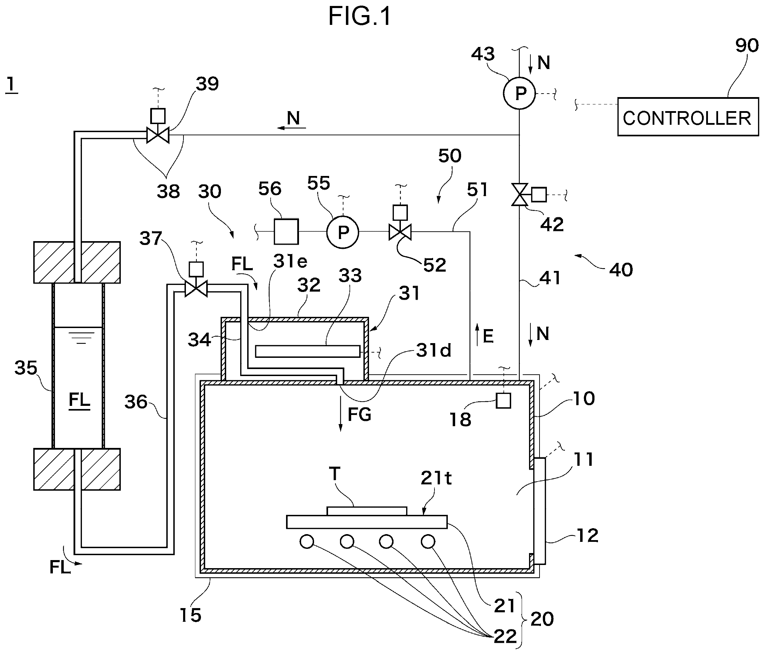

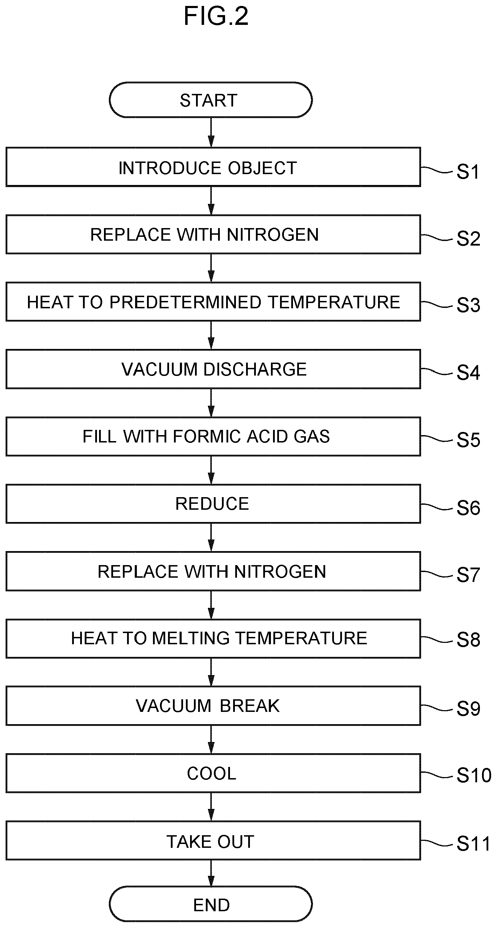

To achieve the above object, a method for manufacturing an oxide-removed object according to the first aspect of the present disclosure is, as shown in FIGs. 1 and 2, for example, a method includes an object introduction step (S1) of introducing an object T into a chamber 10, the object T comprising an oxide; a heating step (S3) of heating the object T, which has been introduced into the chamber 10, to a predetermined temperature; a fluid discharge step (S4) of discharging substantially all of a fluid from the chamber 10 in which the object T is accommodated; after the fluid discharge step (S4) , a reducing gas supply step (S5) of substantially filling the chamber with a reducing gas FG at a pressure that is equal to or higher than 1000 Pa and is lower than a saturated vapor pressure of the reducing gas FG, the reducing gas FG reducing the oxide; and a reduction step (S6) of reducing the oxide in the object T, which has been heated to the predetermined temperature, in an atmosphere of the reducing gas FG.

With such a configuration, it is possible to increase a reduction speed of the oxide in the object, to reduce a time for the reduction step, and to thereby improve productivity.

As for a method for manufacturing an oxide-removed object according to the second aspect of the present disclosure, as shown in FIG. 1, for example, in the method according to the first aspect, the reducing gas FG is formic acid gas.

With such a configuration, it is possible to remove the oxide at a relatively low temperature.

As for a method for manufacturing an oxide-removed object according to the third aspect of the present disclosure, as shown in FIG. 1, for example, in the method according to the first or second aspect, the method further includes a reducing gas condensation suppression step of raising a temperature of a portion having a lowest temperature in the chamber 10 and suppressing condensation of the reducing gas FG.

With such a configuration, it is possible to increase the reducing gas concentration in the chamber while suppressing the condensation of the reducing gas. Therefore, it is possible to increase the reduction speed.

To achieve the above object, an oxide removing apparatus according to the fourth aspect of the present disclosure includes, as shown in FIG. 1, for example, a chamber 10 configured to accommodate an object T having an oxide; a discharge section 50 configured to discharge a fluid from the chamber 10; a heating section 20 configured to heat the object T accommodated in the chamber 10; a reducing gas supply section 30 that has a gasification device 31 configured to produce a reducing gas FG, the reducing gas FG reducing the oxide, wherein the gasification device 31 produces the reducing gas FG by introducing, heating and gasifying a reducing liquid FL, the reducing liquid FL being a liquid precursor to the reducing gas FG, wherein the reducing gas supply section 30 supplies the reducing gas FG produced by the gasification device 31 into the chamber 10; and a controller 90 configured to control the discharge section 50, the heating section 20, and the reducing gas supply section 30 such that, after substantially all of the fluid in the chamber 10, in which the object T is accommodated, is discharged, the chamber 10 is substantially filled with the reducing gas FG at a pressure that is equal to or higher than 1000 Pa and is lower than a saturated vapor pressure of the reducing gas FG, while heating the object T.

With such a configuration, it is possible to increase the reduction speed of the oxide in the object, to reduce the time required for the reduction, and to thereby improve the productivity.

As for an oxide removing apparatus according to the fifth aspect of the present disclosure, as shown in FIG. 1, for example, in the oxide removing apparatus according to the fourth aspect, the apparatus further includes a pressure detection section 18 configured to directly or indirectly detect a pressure in the chamber 10, wherein the controller 90 controls the pressure in the chamber 10 such that a value detected by the pressure detection section 18 reaches a predetermined value.

With such a configuration, it is possible to suppress condensation of the reducing gas in the chamber by controlling the pressure in the chamber.

As for an oxide removing apparatus according to the sixth aspect of the present disclosure, as shown in FIG. 1, for example, in the oxide removing apparatus according to the fifth aspect, the controller 90 controls the pressure in the chamber 10 by regulating an amount of the reducing liquid FL that is to be introduced into the gasification device 31.

With such a configuration, after substantially all the fluid in the chamber is discharged, an amount of the reducing gas that is supplied to the chamber is appropriately regulated. In this way, the pressure in the chamber can be controlled.

As for an oxide removing apparatus according to the seventh aspect of the present disclosure, as shown in FIG. 1, for example, in the oxide removing apparatus according to any one of the fourth to sixth aspects, the apparatus further includes a wall surface temperature implementation part 15 that is attached to the chamber 10 and that is configured to suppress a decrease in a temperature or to increase the temperature of a wall surface of the chamber 10.

With such a configuration, it is possible to maintain or increase the concentration of the reducing gas in the chamber while suppressing the condensation of the reducing gas. Therefore, it is possible to increase the reduction speed.

### ADVANTAGE OF THE INVENTION

With the present disclosure, it is possible to increase a reduction speed of the oxide in the object, to reduce a time for the reduction, and to thereby improve productivity.

### BRIEF DESCRIPTION OF DRAWINGS

FIG. 1 is a schematic system view illustrating an outline configuration of a soldering apparatus according to an embodiment.
FIG. 2 is a flowchart illustrating a procedure for manufacturing a joined object.
FIG. 3 is a graph illustrating changes in a temperature of an object and a pressure in a chamber in a manufacturing process of the joined object.

### DESCRIPTION OF EMBODIMENTS

This application is based on the Patent Application No. 2020-2402 filed on January 9, 2020 in Japan, the contents of which are hereby incorporated in its entirety by reference into the present application, as part thereof.

The present invention will become more fully understood from the detailed description given hereinbelow. Further range of application of the present invention will become clearer from the detailed description given hereinbelow. However, the detailed description and the specific embodiment are illustrated of desired embodiments of the present invention and are described only for the purpose of explanation. Various changes and modifications will be apparent to those ordinary skilled in the art on the basis of the detailed description.

The applicant has no intention to give to public any disclosed embodiment. Among the disclosed changes and modifications, those which may not literally fall within the scope of the patent claims constitute, therefore, a part of the present invention in the sense of doctrine of equivalents.

Description will hereinafter be made of each embodiment with reference to the drawings. The same or corresponding members are denoted with the same reference numerals in all the drawings, and their descriptions are not repeated.

First, with reference to FIG. 1, a description will be made on a soldering apparatus 1 according to an embodiment. FIG. 1 is a schematic system view illustrating an outline configuration of the soldering apparatus 1. The soldering apparatus 1 can remove oxides that an object T as a soldering target has prior to soldering, and also functions as an oxide removing apparatus. The object T has a metal portion on a surface thereof, and the metal portion on the surface of the object T is to be soldered. As the object T, a substrate or an electronic component can be applied. When the object T is soldered without using a flux, in order to remove the oxides in the metal portion on the surface of the object T, reduction by a reducing agent of the oxides is preferable. In this embodiment, formic acid is used as the reducing agent. The soldering apparatus 1 includes: a chamber 10 that defines a space where the object T is soldered; a heating section 20 that heats the object T; a formic acid supply section 30 that supplies formic acid gas FG into the chamber 10; a nitrogen supply section 40 that supplies nitrogen gas N as inert gas into the chamber 10; a discharge section 50 that discharges a fluid from the chamber 10; and a controller 90.

As described above, the chamber 10 defines the space where the object T is soldered. The chamber 10 is formed with a taking in and out opening 11 from which the object T can be taken in and out. The chamber 10 also has an openable and closable shutter 12 so as to be able to close the taking in and out opening 11. The chamber 10 is configured to be able to seal the internal space by closing the taking in and out opening 11 with the shutter 12. As a material and a shape of the chamber 10, such a material and a shape are adopted that can withstand a reduced pressure even when a pressure in the internal space is reduced to a desired pressure (for example, about 10 Pa (an absolute pressure)). In this embodiment, the chamber 10 is formed in a rectangular parallelepiped shape. A chamber heater 15 is provided to cover an outer wall surface of the chamber 10. The chamber heater 15 can increase a temperature of the wall surface of the chamber 10 to a desired temperature and can keep the temperature of the wall surface at the desired temperature. The chamber heater 15 corresponds to the wall surface temperature implementation part. In addition, the chamber 10 is provided with a pressure sensor 18 as a pressure detection section that detects an internal pressure.

The heating section 20 can heat the object T by applying heat thereto. The heating section 20 has: a plate 21 on which the object T is placed; and a lamp 22 for heating the plate 21. In this embodiment, the plate 21 is formed in a board shape and is arranged in the chamber 10. From a perspective of placement stability, a placement surface 21t, on which the object T is placed, of the plate 21 is formed to be flat. Typically, a back surface of the placement surface 21t is also formed to be flat. The plate 21 is formed such that an area of the placement surface 21t is larger than an area of the object T. The plate 21 is typically installed in the chamber 10 in a manner to set the placement surface 21t to be horizontal. However, the plate 21 may be tilted with respect to a horizontal direction (an expansion direction of the placement surface 21t may have a horizontal component and a vertical component) to such a degree that the object T placed thereon can remain to be placed (such a degree that the object T placed thereon does not slip down). The lamp 22 is configured to be able to heat the object T, which is placed on the plate 21, via the plate 21. In this embodiment, in the chamber 10, the lamp 22 is arranged at a position below and near the plate 21. In this embodiment, the lamp 22 is configured that plural infrared lamps are aligned at appropriate intervals along the back surface of the plate 21. The plate 21 is formed of a material capable of transferring the heat generated by the lamp 22 to the object T, and is typically formed of graphite. However, the plate 21 may be formed of metal with high thermal conductivity. Here, an amount of heat that is transferred from the lamp 22 to the object T via the plate 21 is an amount of heat capable of raising a temperature of solder on the object T to a temperature at which the solder can be melted. The plate 21 is typically configured that the temperature thereof can be increased to be higher than a melting point of the solder on the object T. The temperature of the plate 21 that receives the heat from the lamp 22 can be regulated in a stepless or stepped manner. In addition to the above-described melting point of the solder, the temperature of the plate 21 can be regulated to an appropriate reduction temperature for reduction of the oxides in the object T by the formic acid gas FG.

Formic acid that is handled in the formic acid supply section 30 is stored in the form of a liquid (a formic acid liquid FL) in a formic acid liquid container 35 from a perspective of convenience of storage. Then, the formic acid is supplied into the chamber 10 in the form of gas (the formic acid gas FG) from a perspective of exerting reduction power. Formic acid is one type of carboxylic acid that functions as the reducing agent. The formic acid gas FG corresponds to the reducing gas. The formic acid liquid FL corresponds to the reducing liquid. The formic acid supply section 30 corresponds to the reducing gas supply section. The formic acid supply section 30 has a gasification device 31 that produces the formic acid gas FG from the formic acid liquid FL. In this embodiment, in the gasification device 31, a heater 33 is embedded in a metal block 32 having larger heat capacity than the formic acid liquid FL. In addition, the gasification device 31 is formed with a fluid channel 34 through which a formic acid fluid (the formic acid liquid FL, the formic acid gas FG, or a mixed fluid thereof) flows. The gasification device 31 is configured as follows. The formic acid liquid FL flows into the block 32 that is heated by the heater 33 in advance. Then, when flowing through the fluid channel 34, the formic acid liquid FL receives the heat from the block 32 and is gasified. In this way, the formic acid gas FG is produced. In this embodiment, the block 32 of the gasification device 31 is attached to an outer surface of the chamber 10 such that an outlet 31d for the formic acid gas FG is opened into the chamber 10. However, it may be configured to install the block 32 at a position away from the chamber 10 and to connect an outlet for the formic acid gas FG formed in the block 32 to the chamber 10 by a tube. In any case, the gasification device 31 is arranged to be able to supply the produced formic acid gas FG into the chamber 10. The formic acid liquid FL is gasified by the gasification device 31 of the heating type and is then supplied into the chamber 10. Thus, compared to gas containing formic acid, which is produced by bubbling using carrier gas, the highly pure formic acid gas FG that hardly contains components other than formic acid can be supplied to the chamber 10.

The formic acid liquid container 35, which stores the formic acid liquid FL, is preferably formed of a material capable of avoiding or suppressing corrosion caused by formic acid. The formic acid liquid container 35 is typically formed of glass. In the case where a bottle that contains the formic acid liquid FL is commercially available, such a bottle can be used as is as the formic acid liquid container 35. The formic acid liquid container 35 may be placed and used on a load cell so as to manage a remaining amount of the formic acid liquid FL therein. The formic acid liquid container 35 and the gasification device 31 are connected to each other by a supply tube 36. The supply tube 36 is a pipe that constitutes a channel through which the formic acid liquid FL in the formic acid liquid container 35 is delivered to the gasification device 31. The supply tube 36 is provided such that one end thereof communicates with and is opened to inside of the formic acid liquid container 35. The other end of the supply tube 36 is connected to a formic acid liquid inlet 31e of the gasification device 31. A supply gate valve 37 capable of blocking the channel is disposed in the supply tube 36. In addition to the above-described supply tube 36, a pressurization tube 38 is connected to the formic acid liquid container 35. The pressurization tube 38 is a pipe that constitutes a channel through which inert gas (the nitrogen gas N in this embodiment) for pressurizing the inside of the formic acid liquid container 35 is delivered to the formic acid liquid container 35. Here, the nitrogen gas N that is introduced into the formic acid liquid container 35 does not bubble the formic acid liquid FL and is not mixed with the formic acid liquid FL. The pressurization tube 38 is provided such that one end thereof communicates with and is opened to the inside of the formic acid liquid container 35. The other end of the pressurization tube 38 is connected to the nitrogen supply section 40. A pressurization gate valve 39 capable of blocking the channel is disposed in the pressurization tube 38 between the nitrogen supply section 40 and the formic acid liquid container 35. The formic acid liquid FL in the formic acid liquid container 35 can be transferred to the gasification device 31 via the supply tube 36 by opening the supply gate valve 37 and the pressurization gate valve 39 and supplying the nitrogen gas N into the formic acid liquid container 35 via the pressurization tube 38, so as to pressurize the inside of the formic acid liquid container 35.

The nitrogen supply section 40 is configured to supply the nitrogen gas N mainly into the chamber 10 and be also able to supply the nitrogen gas N to the formic acid liquid container 35 as described above. The nitrogen supply section 40 has a nitrogen tube 41, a nitrogen valve 42, and a nitrogen blower 43. The nitrogen tube 41 is a pipe that forms a channel through which the nitrogen gas N is delivered to the chamber 10 from a nitrogen supply source (not illustrated). One end of the nitrogen tube 41 is connected to the nitrogen supply source (not illustrated), and the other end thereof is connected to the chamber 10. The nitrogen valve 42 and the nitrogen blower 43 are provided in the nitrogen tube 41. In this embodiment, the nitrogen valve 42 is arranged on the chamber 10 side while the nitrogen blower 43 is arranged on the nitrogen supply source (not illustrated) side. The nitrogen valve 42 is a member capable of blocking the channel in the nitrogen tube 41. The nitrogen valve 42 is configured to allow a flow of the nitrogen gas N when being opened and to block the flow of the nitrogen gas N when being closed. The nitrogen blower 43 is configured to pressure-feed the nitrogen gas N. An end portion of the pressurization tube 38 is connected to a portion of the nitrogen tube 41 between the nitrogen valve 42 and the nitrogen blower 43. In this way, it is configured to be able to distribute the nitrogen gas N, which is pressure-fed by the nitrogen blower 43 and flows through the nitrogen tube 41, to the pressurization tube 38.

The discharge section 50 is configured to discharge the fluid (mainly the gas) from the chamber 10 to the outside of the chamber 10, and corresponds to the discharge section. The discharge section 50 has a discharge pipe 51, a discharge gate valve 52, a vacuum pump 55, and a catalyst unit 56. The discharge pipe 51 is a pipe that forms a channel through which the fluid in the chamber 10 is delivered to the outside of the system. One end of the discharge pipe 51 is connected to the chamber 10, and the other end thereof is opened to the outside of the system. The discharge gate valve 52, the vacuum pump 55, and the catalyst unit 56 are provided in the discharge pipe 51 and are arranged in this order from the chamber 10 side toward the outside of the system. The discharge gate valve 52 is a member capable of blocking the channel in the discharge pipe 51. The discharge gate valve 52 is configured to allow the flow of the fluid when being opened and to block the flow of the fluid when being closed. The vacuum pump 55 is configured to be able to create a negative pressure in the chamber 10 by discharging the fluid from the chamber 10. The catalyst unit 56 is a device that reduces concentration of formic acid in the fluid discharged from the chamber 10 (hereinafter referred to as a "discharged fluid E") to concentration that does not affect the environment. The catalyst unit 56 is configured to introduce oxygen thereinto in addition to the gas containing formic acid, so as to decompose formic acid into carbon dioxide and water. The catalyst unit 56 is filled with a catalyst that facilitates such decomposition reaction of formic acid. The catalyst unit 56 is configured to reduce concentration of formic acid in the discharged fluid E to about 5 ppm or lower, is preferably configured to reduce the concentration to be lower than 0.2 ppm, and is further preferably configured to reduce the concentration to 0 ppm by optimizing a catalytic condition.

The controller 90 is a device that controls operation of the soldering apparatus 1. The controller 90 is electrically connected to the shutter 12 of the chamber 10 in the wired or wireless manner, and is configured to be able to control opening and closing of the shutter 12. The controller 90 is connected to the chamber heater 15 in the wired or wireless manner, and is configured to be able to control output of the chamber heater 15. The controller 90 is electrically connected to the pressure sensor 18 in the wired or wireless manner, and is configured to be able to receive, as a signal, a result detected by the pressure sensor 18. The controller 90 is connected to the heating section 20 in the wired or wireless manner, and is configured to be able to send a control signal to the heating section 20 and control a heat generation amount (including no heat generation) from the lamp 22. The controller 90 is electrically connected to the gasification device 31 in the wired or wireless manner, and is configured to be able to control activation and stop of the heater 33 in the gasification device 31. The controller 90 is electrically connected to each of the supply gate valve 37, the pressurization gate valve 39, the nitrogen valve 42, and the discharge gate valve 52 in the wired or wireless manner, and is configured to be able to control opening and closing of each of the valves. The controller 90 is electrically connected to each of the nitrogen blower 43 and the vacuum pump 55 in the wired or wireless manner, and is configured to be able to separately control activation and stop of the nitrogen blower 43 and the vacuum pump 55.

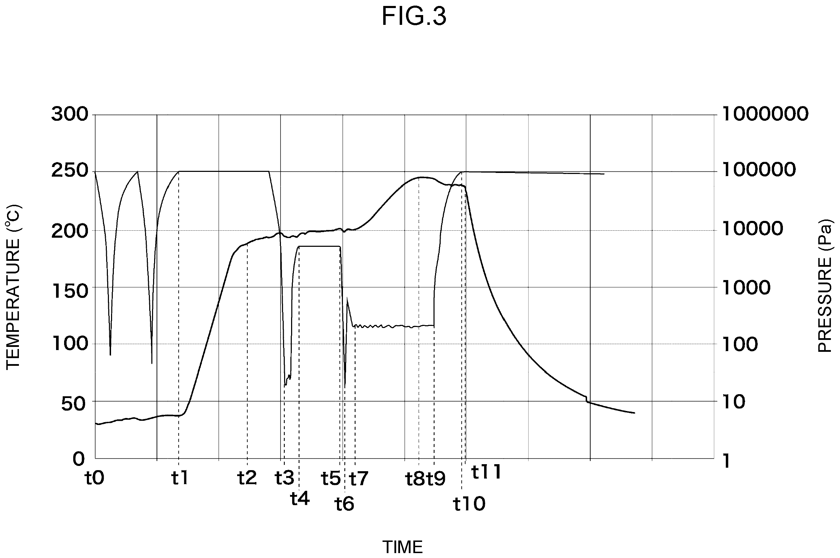

Next, with reference to FIGs. 2 and 3, a description will be made on a method for manufacturing a joined object. The joined object is an object that obtained after the object T is soldered. In the following description, the oxides in the object T are removed in a process of manufacturing the joined object. Thus, it can be said that the joined object is an aspect of the oxide-removed object and that the method for manufacturing the joined object is an aspect of the method for manufacturing an oxide-removed object. FIG. 2 is a flowchart illustrating a procedure for manufacturing the joined object. FIG. 3 is a graph illustrating changes in the temperature of the object T and the pressure in the chamber 10 in a manufacturing process of the joined object. The method for manufacturing the joined object described below is typically executed by using the soldering apparatus 1 that has been described so far, but may be executed by using a different apparatus from the soldering apparatus 1. The following description on the method for manufacturing the joined object by using the soldering apparatus 1 also serves as a description on operation of the soldering apparatus 1. When the configuration of the soldering apparatus 1 is described in the following description, FIG. 1 is appropriately referred.

While the soldering apparatus 1 stops, the shutter 12 is closed, the nitrogen blower 43 and the vacuum pump 55 are stopped, and each of the valves (the supply gate valve 37, the pressurization gate valve 39, the nitrogen valve 42, and the discharge gate valve 52) is closed. In the case where a commercially available container is used as the formic acid liquid container 35 that contains the formic acid liquid FL, the formic acid liquid container 35 is connected to the soldering apparatus 1 before the soldering apparatus 1 is actuated. When the soldering apparatus 1 is actuated, the nitrogen blower 43 and the vacuum pump 55 are activated by the controller 90. The nitrogen blower 43 and the vacuum pump 55 are always running while the soldering apparatus 1 operates. In addition, in this embodiment, the controller 90 activates the heater 33 in the gasification device 31 at actuation timing of the soldering apparatus 1.

Next, the controller 90 causes the shutter 12 of the chamber 10 to open, and then the object T is introduced into the chamber 10 (an object introduction step: S1). The opening and closing operation of the shutter 12 is typically performed by an operator of the apparatus pressing a button (not illustrated) to open and close the shutter 12. When the button is pressed, the controller 90 controls the opening and closing of the shutter 12. Here, in the case where the discharge gate valve 52 is opened to discharge some of the gas from the chamber 10 via the discharge section 50 at the time of opening the shutter 12, it is possible to prevent the gas in the chamber 10 from flowing out of the chamber 10 via the taking in and out opening 11 even when the shutter 12 is opened. As a flow rate of the gas that is discharged from the chamber 10 via the discharge section 50, such a flow rate is sufficient that can set the pressure in the chamber 10 to the negative pressure of such a magnitude capable of preventing the gas in the chamber 10 flowing out from the taking in and out opening 11. In this way, even in the case where the formic acid gas FG remains in the chamber 10, it is possible to prevent the formic acid gas FG as is from flowing out of the chamber 10. After the object T is introduced into the chamber 10, the controller 90 controls the shutter 12 to be closed to seal the chamber 10.

Next, the controller 90 alternately operates the discharge gate valve 52 and the nitrogen valve 42 so as to replace the fluid in the chamber 10 with the nitrogen gas N (S2, t0 to t1). In this embodiment, the discharge gate valve 52 is opened at first. Then, when the pressure in the chamber 10 is reduced to about 100 Pa (the absolute pressure), the discharge gate valve 52 is closed, and the nitrogen valve 42 is opened to introduce the nitrogen gas N into the chamber 10. Thereafter, the nitrogen valve 42 is closed. This step is repeated once or plural times to replace the fluid in the chamber 10 with the nitrogen gas N. Next, the controller 90 controls the lamp 22 of the heating section 20 to turn on, and thereby the object T is heated to a predetermined temperature in the atmosphere of the nitrogen gas N (a heating step S3: t1 to t2). In this embodiment, the predetermined temperature is an appropriate temperature for reducing the oxides in the object T by the formic acid gas FG, and is 180 °C to 220 °C, for example (typically about 200 °C).

After the object T is heated to the predetermined temperature, the controller 90 controls the discharge gate valve 52 to open to reduce the pressure in the chamber 10 to about 50 Pa (the absolute pressure). In this way, substantially all the fluid in the chamber 10 is discharged (a fluid discharge step: S4, t3). Here, in regard to the discharge of substantially all the fluid in the chamber 10, it is intended to discharge substances other than the formic acid gas FG so that concentration of the formic acid gas FG in the chamber 10 reaches desired concentration at the time when the formic acid gas FG is later introduced into the chamber 10. Typically, the discharge of substantially all the fluid in the chamber 10 means discharging 95% or more, preferably 99% or more of the fluid (the gas + the liquid) present in the chamber 10. After substantially all the fluid in the chamber 10 is discharged, the controller 90 controls the discharge gate valve 52 to close.

Next, the controller 90 controls the supply gate valve 37 and the pressurization gate valve 39 to open, and thereby the chamber 10 is substantially filled with the formic acid gas FG such that the pressure in the chamber 10 reaches a predetermined pressure (a reducing gas supply step: S5, t4). Here, filling of the chamber 10 with the formic acid gas FG typically means that the other substance (the substance other than the formic acid gas FG) is not mixed in the chamber 10. In addition, in regard to substantial filling of the chamber 10 with the formic acid gas FG, it is intended to bring the concentration of the formic acid gas FG in the chamber 10 to such concentration that can reduce the oxides in the object T at a desired speed. Typically, substantial filling of the chamber 10 with the formic acid gas FG means a state where the concentration of the formic acid gas FG in the chamber 10 is 95% or higher, preferably 99% or higher. In this embodiment, when the supply gate valve 37 and the pressurization gate valve 39 are opened, the nitrogen gas N is supplied into the formic acid liquid container 35 via the pressurization tube 38, and the formic acid liquid FL in the formic acid liquid container 35 is thereby pressurized. The pressurized formic acid liquid FL in the formic acid liquid container 35 flows into the gasification device 31 from the formic acid liquid inlet 31e via the supply tube 36. At this time, the nitrogen gas N that is supplied into the formic acid liquid container 35 is only used to pressure-feed the formic acid liquid FL and thus is not mixed with the formic acid liquid FL. For this reason, the formic acid liquid FL that flows into the gasification device 31 is the highly pure formic acid liquid FL in which the nitrogen gas N is not mixed. In addition, the block 32 of the gasification device 31 has been heated by the heat of the heater 33, which is activated in advance. Thus, the formic acid liquid FL which flows into the gasification device 31 from the formic acid liquid inlet 31e and flows through the fluid channel 34 receives the heat from the block 32 and is thereby gasified to become the formic acid gas FG. Then, such formic acid gas FG flows into the chamber 10 from the formic acid outlet 31d. As described above, in this embodiment, the highly pure formic acid gas FG is supplied into the chamber 10 after substantially all the fluid in the chamber 10 is discharged. Thus, the chamber 10 is substantially filled with the formic acid gas FG.

In the step of substantially filling the chamber 10 with the formic acid gas FG (S5), in order to set the pressure in the chamber 10 to the predetermined pressure, the controller 90 regulates an opening degree and/or opening and closing timing of the supply gate valve 37 such that the pressure detected by the pressure sensor 18 reaches the predetermined pressure. Just as described, in this embodiment, an amount of the formic acid liquid FL that is introduced into the gasification device 31 is regulated by controlling the supply gate valve 37. In this way, the pressure in the chamber 10 is controlled. The predetermined pressure as a control target herein is a pressure at which the pressure sensor 18 indicates the value determined in advance. In addition, from a perspective of avoiding condensation of the formic acid gas FG in the chamber 10, the predetermined pressure is lower than a saturated vapor pressure of the formic acid gas FG. Meanwhile, from a perspective of increasing a reduction speed at the time of subsequently reducing the oxides in the object T as much as possible, the predetermined pressure is preferably a pressure that is as high as possible and 1000 Pa (the absolute pressure) or higher (preferably 2000 Pa or higher (the absolute pressure) or 3000 Pa or higher (the absolute pressure)). In addition, the predetermined pressure of 6000 Pa (the absolute pressure) or lower is preferred since it is possible to prevent the condensation (liquefaction) of the formic acid gas FG at such a pressure even when the temperature of a portion in the chamber 10 is dropped to about 30 °C. In this embodiment, the predetermined pressure is set to 5000 Pa (the absolute pressure).

When the chamber 10 is substantially filled with the formic acid gas FG such that the pressure in the chamber 10 reaches the predetermined pressure, the oxides in the object T, which is heated to the predetermined temperature, are reduced (a reduction step: S6, t4 to t5). In this embodiment, substantially the only substance that is present in the chamber 10 is the formic acid gas FG. In this way, compared to the conventional case where the formic acid gas and the carrier gas are supplied into the chamber together, the reduction speed can significantly be increased, a time required for the reduction of the oxides in the object T can significantly be reduced, and thus productivity of the joined object can be improved. In this embodiment, it is possible to complete the reduction step (S6) in about 1/10 of the time for the reduction step in the conventional case. When the reduction step (S6) is completed, the oxides present in the object T have been reduced and removed. Thus, the object T at this stage corresponds to the oxide-removed object.

When the reduction of the oxides is terminated, the controller 90 causes the formic acid gas FG in the chamber 10 to be replaced with the nitrogen gas N (S7, t6 to t7). This step can be executed as follows. The formic acid gas FG is discharged from the chamber 10 by the discharge gate valve 52 being opened to reduce the pressure in the chamber 10 to about 50 Pa (the absolute pressure), for example. Thereafter, the discharge gate valve 52 is closed, and the nitrogen valve 42 is opened to supply the nitrogen gas N into the chamber 10. At this time, the pressure in the chamber 10 is preferably set to about 200 Pa (the absolute pressure). This is because, at the pressure of 200 Pa, a void compression effect can appropriately be obtained during subsequent vacuum break while degradation of a heat transfer property is suppressed. Here, the discharged fluid E, which contains the formic acid gas FG discharged from the chamber 10, is delivered to the catalyst unit 56 through the discharge pipe 51, and is subjected to treatment for reducing the concentration of formic acid in the discharged fluid E to concentration that does not affect the environment. Thereafter, the discharged fluid E is discharged from the catalyst unit 56.

After the formic acid gas FG in the chamber 10 is replaced with the nitrogen gas N at the above-described pressure, the controller 90 increases the output of the lamp 22 to heat the object T to a solder melting temperature (S8, t8). In this way, the solder on the object T is melted, and soldering is thereby performed. After soldering is completed, the controller 90 causes the vacuum in the chamber 10 to break by opening the shutter 12, or the like (S9, t9 to t10). When the vacuum in the chamber 10 is broken, the pressure in the chamber 10 is rapidly increased. As a result, a void such as a bubble that can be present in the melted solder is compressed and pushed out by the atmospheric pressure. As a result, the subsequently cooled solder obtains favorable electrical conductivity and has no cavity. After breaking the vacuum in the chamber 10, the controller 90 controls the lamp 22 to turn off, and thereby cooling the inside of the chamber 10 including the object T starts (S10, t11). Thereafter, when the temperature of the melted solder decreases to be equal to or lower than a solidification temperature, the joined object, which is obtained by completing soldering of the object T, is taken out from the chamber 10 (S11). In this way, manufacturing of the joined object is completed. In the flow illustrated in FIG. 2, in order to prevent the condensation of the formic acid gas FG, which has been introduced in the chamber 10, a reducing gas condensation suppression step may be executed. In the reducing gas condensation suppression step, the chamber heater 15 is actuated at necessary timing to increase the temperature of the portion whose temperature is likely to be decreased in the chamber 10 and thereby maintain the temperature of such a portion at a temperature that exceeds a condensation temperature of the formic acid gas FG. The reducing gas condensation suppression step may be executed when the condensation of the formic acid gas FG in the chamber 10 is anticipated. Preferably, the reducing gas condensation suppression step is executed in a period in which the formic acid gas FG is present in the chamber 10 (steps S5 to S6), and may be extended to a period before and/or after the steps S5 to S6 preventively.

As it has been described so far, according to the soldering apparatus 1 and the method for manufacturing the joined object in this embodiment, the chamber 10 is filled with the relatively high concentration of the formic acid gas FG during the reduction of the oxides in the object T. As a result, it is possible to increase the reduction speed of the oxides in the object T to be higher than that in the related art, to reduce the time required for the reduction, and thus to improve the productivity of the joined object. In addition, even in the case where the pressure of the formic acid gas FG, which fills the chamber 10, is set to be high in order to further increase the reduction speed of the oxides in the object T, due to provision of the chamber heater 15, it is possible to suppress the temperature decrease in the chamber 10 and thus to suppress the condensation of the formic acid gas FG. Furthermore, in the case where the pressure of the formic acid gas FG, which fills the chamber 10, is set to 6000 Pa (the absolute pressure) or lower, it is possible to prevent the condensation of the formic acid gas FG even when the temperature of the portion in the chamber 10 is decreased to about 30°C.

In the description that has been made so far, the chamber heater 15 serves as the wall surface temperature implementation part. However, a thermal insulator may be attached to the outer wall of the chamber 10, so as to suppress decrease in the wall surface temperature. In this case, the reducing gas condensation suppression step is executed throughout the manufacturing process of the joined object. However, under a condition that the formic acid gas FG is not condensed, the wall surface temperature implementation part (and the reducing gas condensation suppression step executed by the wall surface temperature implementation part) may not be provided.

In the description that has been made so far, the pressure sensor 18, which directly detects the pressure in the chamber 10, serves as the pressure detection section. However, for example, it may be configured that the amount of the formic acid liquid FL supplied to the gasification device 31 is measured, that the pressure in the chamber 10 at the time of introducing the formic acid gas FG into the chamber 10 is calculated from this measurement value, and that the pressure in the chamber 10 is thereby indirectly detected. Alternatively, another configuration to indirectly detect the pressure in the chamber 10 may be adopted.

In the description that has been made so far, although the formic acid gas FG is used as the reducing gas, carboxylic acid gas, hydrogen, or the like other than the formic acid gas FG may be used. However, from perspectives of ease of obtainment and convenience of the soldering processing, the formic acid gas FG is preferably used as the reducing gas.

In the description that has been made so far, the soldering apparatus and the method for manufacturing the joined object according to the embodiments of the present disclosure have been described mainly with reference to FIGs. 1 to 3 as the example. However, the configurations, structures, numbers, arrangements, shapes, materials, and the like of each of the sections are not limited to the above specific example. The components that are appropriately and selectively adopted by the person skilled in the art are included in the scope of the present invention as long as the gist of the present invention is included.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and similar referents in the context of describing the invention (especially in the context of the following claims) is to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A method for manufacturing an oxide-removed object, comprising:
an object introduction step of introducing an object into a chamber, the object comprising an oxide;
a heating step of heating the object, which has been introduced into the chamber, to a predetermined temperature;
a fluid discharge step of discharging substantially all of a fluid from the chamber in which the object is accommodated;
after the fluid discharge step, a reducing gas supply step of substantially filling the chamber with a reducing gas at a pressure that is equal to or higher than 1000 Pa and is lower than a saturated vapor pressure of the reducing gas, the reducing gas reducing the oxide; and
a reduction step of reducing the oxide in the object, which has been heated to the predetermined temperature, in an atmosphere of the reducing gas.

2. The method according to claim 1,
wherein the reducing gas is formic acid gas.

3. The method according to claim 1 or 2, further comprising:
a reducing gas condensation suppression step of raising a temperature of a portion having a lowest temperature in the chamber and suppressing condensation of the reducing gas.

4. An oxide removal apparatus, comprising:
a chamber configured to accommodate an object having an oxide;
a discharge section configured to discharge a fluid from the chamber;
a heating section configured to heat the object accommodated in the chamber;
a reducing gas supply section that has a gasification device configured to produce a reducing gas, the reducing gas reducing the oxide, wherein the gasification device produces the reducing gas by introducing, heating and gasifying a reducing liquid, the reducing liquid being a liquid precursor to the reducing gas, wherein the reducing gas supply section supplies the reducing gas produced by the gasification device into the chamber; and
a controller configured to control the discharge section, the heating section, and the reducing gas supply section such that, after substantially all of the fluid in the chamber, in which the object is accommodated, is discharged, the chamber is substantially filled with the reducing gas at a pressure that is equal to or higher than 1000 Pa and is lower than a saturated vapor pressure of the reducing gas, while heating the object.

5. The oxide removal apparatus according to claim 4, further comprising:
a pressure detection section configured to directly or indirectly detect a pressure in the chamber,
wherein the controller controls the pressure in the chamber such that a value detected by the pressure detection section reaches a predetermined value.

6. The oxide removal apparatus according to claim 5, wherein
the controller controls the pressure in the chamber by regulating an amount of the reducing liquid that is to be introduced into the gasification device.

7. The oxide removal apparatus according to any one of claims 4 to 6, further comprising:
a wall surface temperature implementation part that is attached to the chamber and that is configured to suppress a decrease in a temperature or to increase the temperature of a wall surface of the chamber.
